(19) Europäisches Patentamt
European Patent Office
Office européen des brevets

(11) Veröffentlichungsnummer: **0 206 158 B1**

(12) # EUROPÄISCHE PATENTSCHRIFT

(45) Veröffentlichungstag der Patentschrift: **20.02.91**

(51) Int. Cl.5: **C08G 18/81**, C08G 18/48, G03F 7/004, G03C 1/72, H01B 3/42, H01B 3/36, G02F 1/11

(21) Anmeldenummer: **86108067.9**

(22) Anmeldetag: **12.06.86**

Die Akte enthält technische Angaben, die nach dem Eingang der Anmeldung eingereicht wurden und die nicht in dieser Patentschrift enthalten sind.

(54) **Photopolymere auf Polyetherbasis.**

(30) Priorität: **24.06.85 DE 3522537**

(43) Veröffentlichungstag der Anmeldung:
**30.12.86 Patentblatt 86/52**

(45) Bekanntmachung des Hinweises auf die Patenterteilung:
**20.02.91 Patentblatt 91/08**

(84) Benannte Vertragsstaaten:
**AT BE CH DE FR GB IT LI LU NL SE**

(56) Entgegenhaltungen:
**EP-A- 0 021 824**
**US-A- 3 776 889**
**US-A- 4 287 323**
**US-A- 4 320 221**

(73) Patentinhaber: **Siemens Aktiengesellschaft**
**Wittelsbacherplatz 2**
**D-8000 München 2(DE)**

(72) Erfinder: **Ahne, Hellmut, Dr. Dipl.-Chem.**
**Heidestrasse 6**
**D-8551 Röttenbach(DE)**
Erfinder: **Plundrich, Winfried**
**Dürerstrasse 14**
**D-8501 Kalchreuth(DE)**

**EP 0 206 158 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft Photopolymere auf Polyetherbasis, welche aus Additionsprodukten aus einem olefinisch ungesättigten Monoisocyanat und einem hydroxylgruppenhaltigen Phenoxyharz bestehen, sowie die Herstellung und Verwendung von derartigen Photopolymeren.

Photopolymere, d.h. photoreaktive bzw. photovernetzbare Polymere, auf Polyetherbasis sind bereits bekannt (DE-OS 25 03 526). Diese Photopolymeren sind 3-(2-Furyl)-acrylsäureester von Phenoxyharzen mit einem Molekulargewicht von wenigstens etwa 15000, welche im graphischen Gewerbe, insbesondere für lithographische Druckplatten und Ätzresists, verwendet werden. Bei der Herstellung der bekannten Photopolymeren, die durch Veresterung der Phenoxyharze mit Furylacrylsäurederivaten erfolgt, wird vorzugsweise vom Säurechlorid, d.h. von Furylacryloylchlorid, ausgegangen. Da Photopolymere auf verschiedenen Anwendungsgebieten aber keine Chloridionen enthalten dürfen, weil diese zu vorzeitiger Korrosion führen, sind hierbei aufwendige Reinigungsoperationen erforderlich, um die Chloridionen aus den Veresterungsprodukten zu entfernen. Dies wiederum führt aber zu einer Verteuerung der hergestellten Produkte.

Aus der US-PS 3 776 889 sind lichtempfindliche, in organischen Lösungsmitteln lösliche, filmbildende Polymere bekannt, die im wesentlichen aus einem Allylcarbamylester eines hydroxylgruppenhaltigen Polymeren bestehen, das ein Molekulargewicht von 500 bis 115000 aufweist. Als hydroxylgruppenhaltige Polymere dienen dabei Phenoxyharze, Polyvinylalkohol, Polyester, Polyurethanharze und Schellack. Diese hydroxylgruppenhaltigen Polymeren werden mit Allylisocyanat verestert, wobei die licht empfindlichen Polymeren entstehen. Die lichtempfindlichen Polymeren gelangen in photomechanischen Prozessen und in der Photolithographie zum Einsatz, d.h. zur Herstellung photographischer Resistbilder.

Photopolymere werden beispielsweise in der Feinstleitertechnik als Lötstopp- und Isolierlack benötigt. Derartige Photopolymere müssen aber ein spezielles Eigenschaftsspektrum aufweisen, sie müssen nämlich wärmebeständig sein und sich zu lötbadresistenten, rißfreien Filmen verarbeiten lassen und sie müssen bei einmaliger Beschichtung von korrosionsempfindlichen Schaltungen diese wirksam gegen Feuchte und Korrosion schützen. Darüber hinaus müssen derartige Photopolymere präparativ einfach und damit preisgünstig herstellbar sein und mit kurzen Belichtungs-, Entwicklungs- und Aushärtungszeiten kostengünstig verarbeitet werden können.

Als Lötstopplacke auf der Basis von Photopolymeren werden bislang Epoxidharze mit eingebauten photoreaktiven Chalkongruppen verwendet. Nachteilig bei diesen Lötstopplacken ist, daß daraus hergestellte Lackschichten nur dann auch als Korrosionsschutz wirksam sind, wenn eine aufwendige Mehrfachbeschichtung erfolgt. Wegen der kurzkettigen Polymerbasis ist ferner eine mehrstündige thermische Nachhärtung erforderlich. Darüber hinaus ist das Herstellungsverfahren für die Lötstopplacke aufwendig und damit teuer.

Aufgabe der Erfindung ist es, Photopolymere auf Polyetherbasis der eingangs genannten Art bereitzustellen, welche ohne aufwendige Reinigungsoperationen und damit kostengünstig herstellbar sind und somit auch für Anwendungen auf dem Schaltungs- und Leitungssektor als Schutz- und Isolierschichten geeignet sind.

Dies wird erfindungsgemäß dadurch erreicht, daß bei den photoreaktiven Polyethern, welche aus Additionsprodukten aus einem olefinisch ungesättigten Monoisocyanat und einem hydroxylgruppenhaltigen Phenoxyharz bestehen, das olefinisch ungesättigte Monoisocyanat ein methacrylatgruppenhaltiges Isocyanat oder ein Additionsprodukt von Hydroxyethylacrylat oder -methacrylat an 2.4-Diisocyanatotoluol ist.

Bei den erfindungsgemäßen Photopolymeren sind die photoreaktiven Gruppen, d.h. die die olefinisch ungesättigte Struktur enthaltenden Gruppen, über Urethanbrücken, welche bei der Addition der Monoisocyanate an die Hydroxylgruppen der Polyhydroxyether gebildet werden, an das Basispolymer gebunden. Photoreaktive Polyether mit einer derartigen Struktur weisen ein überraschendes Eigenschaftsspektrum auf.

Die erfindungsgemäßen photoreaktiven Polyether sind präparativ sehr einfach und gelfrei herzustellen. Sie zeichnen sich durch eine hohe Löslichkeit in vielen Lösungsmitteln bzw. Lösungsmittelgemischen mit einem breiten Siedepunktsbereich aus. Daraus hergestellte Lösungen mit einem weiten Viskositätsbereich von ca. 10 bis 5000 mPa.s bleiben bei Raumtemperatur über Monate hinweg gelfrei und sind damit überraschend lange lagerstabil. Mit diesen Lösungen können in nur einem Beschichtungsvorgang transparente helle Filme mit einer glatten homogenen Oberfläche in einem breiten Schichtdickenbereich von beispielsweise 0,01 bis 500 µm erzeugt werden. Die Schichten sind von hoher Reinheit und Feuchteresistenz, sie zeigen darüber hinaus gute elektrische Kennwerte, die sich auch im Feuchteklima überraschenderweise nicht bzw. nur unwesentlich ändern.

Die erfindungsgemäßen photoreaktiven Polyether entsprechen somit den Forderungen an einen Photolack für die Feinstleitertechnik mit dauerhafter Schutzfunktion. Außerdem kann dabei der Fertigungsprozeß verkürzt werden, weil wegen der ausreichend hohen Kettenlänge der Polymeren eine thermische Nachhärtung - wie bei photoreaktiven Epoxidharzen - nicht erforderlich ist.

Aus den erfindungsgemäßen Photopolymeren hergestellte Schichten zeichnen sich dadurch aus, daß sie unter Lötbadbedingungen in ihrer Oberflächenqualität nicht beeinträchtigt werden. Darüber hinaus ist die Haftung zum Lot so gering, daß ein unerwünschtes Kleben von Lotperlen an der Schichtoberfläche vermieden wird.

Die erfindungsgemäßen Photopolymeren können durch Strahlung vernetzt und dadurch in Polymere mit hoher Wärmeformbeständigkeit übergeführt werden (siehe dazu EP-OS 0 206 159).

Die erfindungsgemäßen Photopolymeren sind Additionsprodukte von Polyhydroxyethern und Monoisocyanaten, wobei als Polyhydroxyether Phenoxyharze dienen. Die Phenoxyharze weisen dabei vorteilhaft ein Molekulargewicht etwa zwischen 15000 und 30000 auf. Derartige Phenoxyharze sind im Handel erhältlich, beispielsweise als Rütapox 0723 und Rütapox 0717 (Rütapox[R] ist ein Warenzeichen der Fa. Rütgerswerke AG). Als Monoisocyanate finden methacrylatgruppenhaltige Isocyanate, wie Isocyanatoethylmethacrylat, und das Additionsprodukt von Hydroxyethylacrylat oder -methacrylat an 2.4-Diisocyanatotoluol sowie Gemische dieser Verbindungen Verwendung.

Anhand der nachfolgenden Formeln wird die Struktur der erfindungsgemäßen photoreaktiven Polymeren auf Polyetherbasis beispielhaft verdeutlicht:

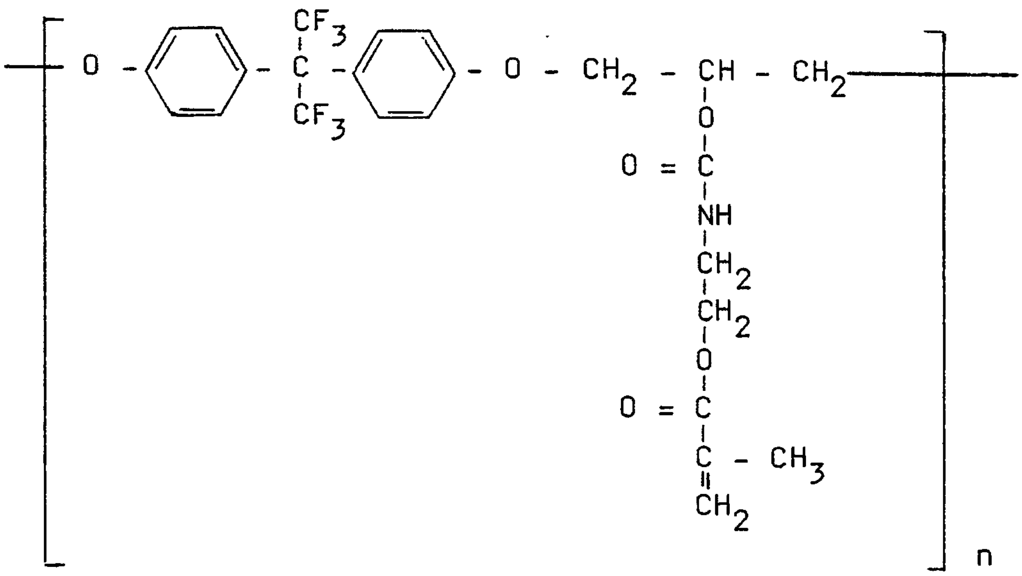

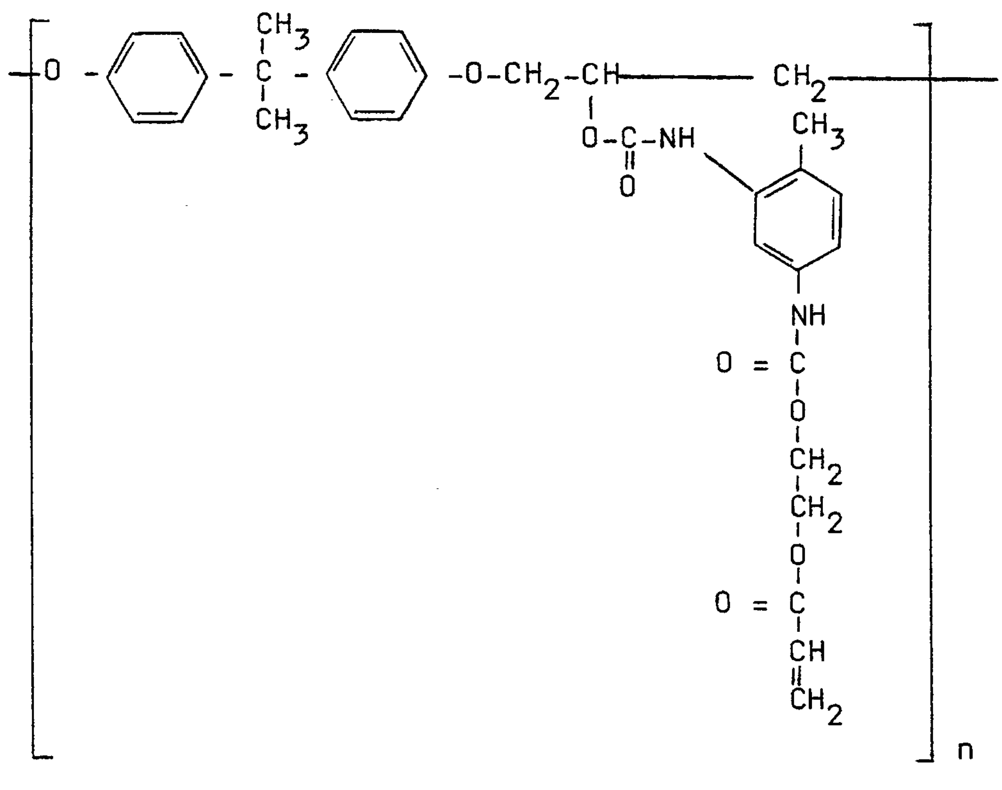

dabei ist n ≧ 50.

Die erfindungsgemäßen Photopolymeren werden in der Weise hergestellt, daß ein olefinisch ungesättigtes Monoisocyanat in Form eines methacrylatgruppenhaltigen Isocyanats oder eines Addi tionsproduktes Von Hydroxyethylacrylat bzw. -methacrylat an 2.4-Diisocyanatotoluol in einem organischen Lösungsmittel in Gegenwart eines Katalysators und/oder bei erhöhter Temperatur mit einem hydroxylgruppenhaltigen Phenoxyharz zur Reaktion gebracht wird. Wird dabei ein Katalysator verwendet, so wird im allgemeinen bei Raumtemperatur gearbeitet. Als Katalysator wird vorzugsweise 1.4-Diazabicyclo[2.2.2]octan oder Dibutylzinndilaurat eingesetzt.

Die bei der Additionsreaktion zwischen Monoisocyanat und Polyhydroxyether gebildeten Produkte können in reiner Form isoliert werden. Für eine Weiterverarbeitung ist es jedoch besonders vorteilhaft und kostengünstig, die Reaktionslösung direkt zu verwenden, beispielsweise zur Beschichtung von Substraten. Dabei ist auch von Vorteil, daß die Lösungen der Photopolymeren lagerstabil sind. Im übrigen ist eine

Isolierung der Photopolymeren vor der Weiterverarbeitung auch deshalb nicht erforderlich, weil deren Synthese chloridfrei verläuft.

Außer zur Verwendung als Photoresist und zur Herstellung von Schutz- und Isolierschichten, wobei eine Photostrukturierung erfolgt, können die erfindungsgemäßen Photopolymeren auch allgemein - in nichtstrukturierter Form - zur Herstellung von mit UV-Licht härtbaren Schutz- und Isolierüberzügen auf langgestrecktem Gut, wie Leitungen, und auf Substratflächen verwendet werden. Ferner können diese Photopolymeren zur Strukturierung von Substratflächen mittels Siebdrucktechnik, insbesondere von thermisch empfindlichen Substratflächen, verwendet werden, beispielsweise bei der Herstellung von Dämpfungsmassen für Oberflächenwellenfilter, wie Fernsehzwischenfrequenzfilter. Dabei kann dann anstelle einer thermischen Behandlung auch eine UV-Härtung erfolgen.

Anhand von Ausführungsbeispielen soll die Erfindung noch näher erläutert werden.

Beispiel 1

Zur Herstellung eines olefinisch ungesättigten, d.h. photoreaktiven Monoisocyanats werden zu 69,2 Masseteilen getrocknetes Dichlormethan unter Feuchteausschluß 40 Masseteile reines 2.4-Diisocyanatotoluol und zu der dabei erhaltenen Lösung dann unter Rühren langsam 29,2 Masseteile 2-Hydroxyethylacrylat getropft. Die Reaktion wird bei Raumtemperatur durchgeführt. Nach beendeter Reaktion wird die Lösung 24 Stunden bei Raumtemperatur stehen gelassen, durch Titration der Isocyanatgruppen wird dann ein Umsatz von 99 % festgestellt. Die Reaktionslösung kann direkt zur weiteren Umsetzung eingesetzt werden. Das photoreaktive Monoisocyanat läßt sich aber durch Extraktion mit Petroleumbenzin auch in Form einer klaren viskosen Flüssigkeit als Reinsubstanz isolieren; die Charakterisierung erfolgt durch NCO-Titration.

Zu 35 Masseteilen des Phenoxyharzes Rütapox 0717 werden bei Raumtemperatur und unter Rühren 140 Masseteile trockenes γ-Butyrolacton, 135 Masseteile trockenes N-Methylpyrrolidon und 50 Masseteile des in der vorstehend beschriebenen Weise hergestellten photoreaktiven Monoisocyanats sowie 0,1 Masseteile Dibutylzinndilaurat gegeben. Die dabei erhaltene Lösung wird bei Raumtemperatur 48 Stunden gerührt und danach mit 7 Masseteilen Ethanol versetzt, um restliche Isocyanatgruppen abzustoppen. Nach einer Reaktionszeit von ca. 24 Stunden sind keine Isocyanatgruppen mehr nachweisbar und die Reaktionslösung ist, beispielsweise für Beschichtungen, gebrauchsfähig; die Viskosität beträgt bei 23 °C 830 mPa.s.

Beispiel 2

Zu einer Lösung von 110 Masseteilen Rütapox 0723 (50%ige Lösung in Cyclohexanon/Ethylglycolacetat) in 114 Masseteilen γ-Butyrolacton werden 33 Masseteile reines Isocyanatoethylmethacrylat und 0,1 Masseteile Dibutylzinndilaurat gegeben, und dann wird bei Raumtemperatur 50 Stunden gerührt. Danach werden zur Reaktionslösung 9 Masseteile 2-Hydroxyethylmethacrylat gegeben, um restliche Isocyanatgruppen umzusetzen. Die Lösung wird dann 24 Stunden bei Raumtemperatur stehen gelassen. Anschließend werden 3,5 Masseteile Dichloracetophenon und 0,9 Masseteile Michler's Keton zugesetzt, wonach die Lösung gebrauchsfertig ist. Durch Aufschleudern auf Aluminiumsubstrate und zweistündiges Trocknen bei 70 °C werden 100 µm dicke homogene Schichten erhalten, die bei Bestrahlung mit einer 350 W-Quecksilberhöchstdrucklampe innerhalb von 20 s photochemisch vernetzt und damit in Lösungsmitteln, wie γ-Butyrolacton/Xylol, unlöslich werden.

Beispiel 3

Zu 113,2 Masseteilen getrocknetes Dichlormethan werden unter Feuchteausschluß 62 Masseteile 2.4-Diisocyanatotoluol und danach bei Raumtemperatur und unter Rühren langsam 51,2 Masseteile 2-Hydroxyethylmethacrylat getropft. Nach 24stündiger Reaktion bei Raumtemperatur wird der Isocyanatumsatz titrimetrisch zu 99 % ermittelt. Durch Zugabe von 450 Masseteilen Petroleumbenzin wird ein Niederschlag von weißen Kristallen erhalten. Die Ausbeute an reinem photoreaktiven Monoisocyanat beträgt 93 %.

Die Charakterisierung des Monoisocyanats erfolgt NMR-spektroskopisch (Lösungsmittel: $CDCl_3$; innerer Standard: TMS). Dabei ergeben sich folgende Peaks: Singuletts bei 1,98 ppm ( $-CH_3$ von Methacrylat), 2,22 ppm ( $-CH_3$ am Aromaten), 4,41 ppm ( $-O-CH_2-CH_2-O-$), 5,61 und 6,15 ppm (olefinische Protonen) sowie 7,04 und 7,22 ppm (aromatische Protonen). Ein Vergleich mit den Spektren von Bisadditionsprodukten (kein Singulett bei 2,22 ppm) und Gemischen zeigt, daß das 2-Hydroxyethylmethacrylat bei der durchgeführten

Reaktion nur an eine Isocyanatgruppen addiert wurde, und dies ist - wie bekannt - die sterisch ungehinderte 4-Stellung.

Zu einer Lösung von 95 Masseteilen des in der vorstehend beschriebenen Weise hergestellten photoreaktiven Monoisocyanats in einem Gemisch von 140 Masseteilen γ-Butyrolacton, 105 Masseteilen N-Methylpyrrolidon und 0,01 Masseteilen Dibutylzinndilaurat werden unter Feuchteausschluß 125,2 Masseteile einer Phenoxyharzlösung (Rütapox 0723) gegeben und unter Rühren bei einer Temperatur von 50 °C zur Reaktion gebracht (Dauer: 12 Stunden). Danach werden bei dieser Temperatur zur Reaktionslösung zunächst 8 Masseteile 2-Hydroxyethylmethacrylat und nach weiteren 5 Stunden 4 Masseteile Ethanol gegeben. Nach 24 Stunden weist die Harzlösung eine Viskosität von 330 mPa.s auf und ist für die Durchführung von Beschichtungen gebrauchsfertig.

Beispiel 4

Zu einer Lösung von 66,8 Masseteilen reinem 2.4-Diisocyanatotoluol in 115,3 Masseteilen Dichlormethan wird bei Raumtemperatur unter Rühren und Feuchteausschluß ein Gemisch von 23,6 Masseteilen reinem 2-Hydroxyethylacrylat und 24,8 Masseteilen reinem 2-Hydroxyethylmethacrylat langsam zugetropft. Nach einer Reaktionsdauer von 30 Stunden bei Raumtemperatur wird durch Titration ein Isocyanatumsatz von 98 % ermittelt.

Die erhaltene Lösung des photoreaktiven Monoisocyanats wird mit einer Lösung von 107 Masseteilen Rütapox 0717 in 397 Masseteilen γ-Butyrolacton und mit 0,22 Masseteilen Dibutylzinndilaurat vereinigt. Nach 25stündiger Reaktion bei Raumtemperatur werden zur Reaktionslösung 15 Masseteile Ethanol gegeben. Nach weiteren 24 Stunden ist die Lösung für Beschichtungen gebrauchsfertig.

## Ansprüche

1. Photopolymere auf Polyetherbasis, bestehend aus Additionsprodukten aus einem olefinisch ungesättigten Monoisocyanat und einem hydroxylgruppenhaltigen Phenoxyharz, **dadurch gekennzeichnet,** daß das olefinisch ungesättigte Monoisocyanat ein methacrylatgruppenhaltiges Isocyanat oder ein Additionsprodukt von Hydroxyethylacrylat oder -methacrylat an 2.4-Diisocyanatotoluol ist.

2. Photopolymere nach Anspruch 1, **dadurch gekennzeichnet**, daß das Phenoxyharz ein Molekulargewicht von 15000 bis 30000 besitzt.

3. Photopolymere nach Anspruch 1 oder 2, **dadurch gekennzeichnet**, daß das methacrylatgruppenhaltige Isocyanat Isocyanatoethylmethacrylat ist.

4. Verfahren zur Herstellung von Photopolymeren nach einem der Ansprüche 1 bis 3, **dadurch gekennzeichnet**, daß ein olefinisch ungesättigtes Monoisocyanat in Form eines methacrylatgruppenhaltigen Isocyanats oder eines Additionsproduktes von Hydroxyethylacrylat bzw. -methacrylat an 2.4-Diisocyanatotoluol in einem organischen Lösungsmittel in Gegenwart eines Katalysators und/oder bei erhöhter Temperatur mit einem hydroxylgruppenhaltigen Phenoxyharz zur Reaktion gebracht wird.

5. Verfahren nach Anspruch 4, **dadurch gekennzeichnet**, daß als Katalysator Dibutylzinndilaurat verwendet wird.

6. Verfahren nach Anspruch 4, **dadurch gekennzeichnet**, daß als Katalysator 1.4-Diazabicyclo[2.2.2]-octan verwendet wird.

7. Verwendung der Photopolymeren nach einem der Ansprüche 1 bis 3 zur Herstellung UV-härtbarer Kunststoffüberzüge auf langgestrecktem Gut, wie Leitungen, und auf Substratflächen.

8. Verwendung der Photopolymeren nach einem der Ansprüche 1 bis 3 zur Herstellung von Dämpfungsmassen für Oberflächenwellenfilter, wie Fernsehzwischenfrequenzfilter.

## Claims

1. Polyether-based photopolymers consisting of addition products of an olefin-unsaturated monoisocyanate and a hydroxyl group-containing phenoxy resin, **characterised in that** the olefin-unsaturated monoisocyanate is a methacrylate group-containing isocyanate, or an addition product of hydroxyethyl acrylate or hydroxyethyl methacrylate and 2,4-diisocyanatotoluene.

2. Photopolymers according to claim 1, **characterised in that** the phenoxy resin has a molecular weight of 15,000 to 30,000.

3. Photopolymers according to claim 1 or 2, **characterised in that** the methacrylate group-containing isocyanate is isocyanatoethyl methacrylate.

4. Process for the production of photopolymers according to one of claims 1 to 3, **characterised in that** an olefin-unsaturated monoisocyanate in the form of a methacrylate group-containing isocyanate, or an addition product of hydroxyethyl acrylate or hydroxyethyl methacrylate and 2,4-diisocyanatotoluene is caused to react, in an organic solvent in the presence of a catalyst and/or at an elevated temperature, with a hydroxyl group-containing phenoxy resin.

5. Process according to claim 4, **characterised in that** dibutyl tin dilaurate is used as catalyst.

6. Process according to claim 4, **characterised in that** 1,4-diazabicyclo[2,2,2]octane is used as catalyst.

7. Use of the photopolymers according to one of claims 1 to 3 for the production of UV-hardenable plastics coatings for elongated products such as transmission lines, and for substrate surfaces.

8. Use of the photopolymers according to one of claims 1 to 3 for the production of damping substances for surface wave filters, such as television intermediate frequency filters.

## Revendications

1. Photopolymères à base de polyétheroxyde, constitués de produits d'addition d'un monoisocyanate à insaturation oléfinique et d'une résine phénoxylique contenant des groupes hydroxyle, caractérisés en ce que le monoisocyanate à insaturation oléfinique est un isocyanate contenant un groupe méthacrylate ou un produit d'addition d'acrylate d'hydroxyéthyle ou de méthacrylate d'hydroxyéthyle et de 2,4-diisocyanatotoluène.

2. Photopolymères suivant la revendication 1, caractérisés en ce que la résine phénoxylique a une masse moléculaire de 15000 à 30000.

3. Photopolymères suivant la revendication 1 ou 2, caractérisés en ce que l'isocyanate contenant un groupe méthacrylate est du méthacrylate d'isocyanatoéthyle.

4. Procédé de préparation de photopolymères suivant l'une des revendications 1 à 3, caractérisé en ce qu'il consiste à faire réagir un monoisocyanate à insaturation oléfinique, sous la forme d'un isocyanate contenant un groupe méthacrylate ou d'un produit d'addition d'acrylate d'hydroxyéthyle ou de méthacrylate d'hydroxyéthyle et de 2,4-diisocyanatotoluène, dans un solvant organique, en présence d'un catalyseur et/ou à température élevée, sur une résine phénoxylique contenant des groupes hydroxyle.

5. Procédé suivant la revendication 4, caractérisé en ce qu'il consiste à utiliser, comme catalyseur, du dilaurate de dibutylétain.

6. Procédé suivant la revendication 4, caractérisé en ce qu'il consiste à utiliser, comme catalyseur, du 1,4-diazabicyclo[2,2,2]octane.

7. Utilisation des photopolymères suivant l'une des revendications 1 à 3, pour la préparation de revêtements de matières plastiques durcissables par la lumière ultraviolette, sur des produits oblongs,

comme des conducteurs, et sur les surfaces de substrats.

8. Utilisation des photopolymères suivant l'une des revendications 1 à 3, pour la préparation de masses d'atténuation pour des filtres à ondes de surface, comme des filtres de fréquences intermédiaires de télévision.